# EUROPÄISCHE PATENTANMELDUNG

(11) **EP 1 193 775 A1**
(43) Veröffentlichungstag der Anmeldung: **03.04.2002**
(21) Anmeldenummer: 00810897.9
(22) Anmeldetag: 29.09.2000
(51) Int. Cl.: H01L 39/24, C04B 35/45

(54) **Verfahren zur Herstellung hochtemperatur-supraleitender Formteile**

(71) Anmelder: ABB RESEARCH LTD., 8050 Zürich (CH)
(72) Erfinder: Chen, Makan, Dr., 5405 Baden-Dättwil (CH); Hoidis, Markus, 5442 Fislisbach (CH)
(74) Vertreter: ABB Patent Attorneys

(57) **Zusammenfassung**

Die vorliegende Erfindung hat ein vereinfachtes Verfahren zur Herstellung supraleitender Formteile zum Gegenstand, welches insbesondere zur Präparation mittels Foliengiessen von dikken, untexturierten Schichten aus Bi2212 mit einer kritischen Stromdichte von einigen tausend A/cm² geeignet ist. Erfindungsgemäss wird das Precursormaterial auf trockenem Weg, d.h. ohne nasschemische Zwischenschritte, hergestellt und in einem bevorzugt zweistufigen Kalzinierprozess nur teilweise reagiert, d.h. nicht vollständig in die supraleitende Phase überführt. Um Formänderungen des Precursors während dem partiellen Schmelzschritt zu ermöglichen, ist eine Pufferschicht zwischen dem Formteil und seiner Unterlage vorgesehen.

## Beschreibung

### TECHNISCHES GEBIET

Die vorliegende Erfindung bezieht sich auf das Gebiet der Hochtemperatursupraleitung. Sie betrifft ein Verfahren zur Herstellung von Formteilen auf der Basis eines BiSrCaCuO-haltigen Hochtemperatursupraleiters gemäss dem Oberbegriff des Patentanspruchs 1.

### STAND DER TECHNIK

Für Anwendungen von Hochtemperatursupraleitern im Bereich der Energieübertragung sind hohe Nennströme von einigen hundert Ampere gefragt, was kritische Stromstärken in ähnlicher Grössenordnung in den supraleitenden Bauteilen wie beispielsweise Übertragungskabel, Transformatoren, Magnetspulen oder Strombegrenzer verlangt. Eine hohe Stromstärke lässt sich durch eine hohe Stromdichte oder einen grossen Leiterquerschnitt realisieren. Hohe kritische Stromdichten j_{c} im Bereich von 10⁶ A/cm² können in dünnen, vornehmlich einkristallinen oder hochtexturierten Schichten mittels aufwändiger, vakuumbasierter Verfahren erreicht werden. Eine Erhöhung der Schichtdicke über einige µm ist dabei aber nicht ohne Einbusse bei j_{c} möglich. Andererseits sind grosse Leiterquerschnitte mit polykristallinen keramischen Formteilen (englisch bulk conductors), beispielsweise als texturierte oder untexturierte dikke Schichten, erzielbar. Wegen der im praktischen Einsatz unvermeidlichen Wechselstromverluste stehen dabei wiederum flache bandförmige Leiter mit Schichtdicken zwischen 10 µm und einigen mm mit kritischen Stromdichten von einigen tausend A/cm² im Vordergrund.

Für Anwendungen im Bereich der Energieübertragung werden die Hochtemperatursupraleiter der YBC0123, Bi2212 oder Bi2223 Familien mit der nominalen stöchiometrischen Zusammensetzung YBa₂Cu₃Oₓ, Bi₂Sr₂CaCu₂O_{8+δ} und Bi₂Sr₂Ca₂Cu₃O_{10+δ}, wobei Bi teilweise durch Pb ersetzt sein kann, als erfolgversprechend angesehen. Unter diesen Materialien lässt sich polykristallines Bi2212 am einfachsten herstellen und wird deshalb im Folgenden bevorzugt beschrieben.

Ein aus der herkömmlichen Oxidkeramikverarbeitung bekanntes, Foliengiessen (tape casting, doctor blade process) genanntes Verfahren zur Herstellung von hochtemperatursupraleitenden Formteilen in Form von Schichten mit Dicken von bis zu einigen 100 µm ist in der EP-A 0 283 197 dargestellt. Dabei wird ein feinkörniges, pulverförmiges Precursormaterial in einem Lösungsmittel unter Zugabe von organischen Additiven dispergiert. Letztere umfassen Dispergierhilfsmittel, Bindemittel sowie Weichmacher zur Erzielung einer optimalen Viskosität der Foliengiessmasse (slurry). Die Foliengiessmasse läuft aus einem über eine Unterlage bewegten Behälter durch einen verstellbaren Spalt kontinuierlich auf die genannte Unterlage. Anschliessend werden die Lösungsmittel verdampft, die so erhaltene Grünfolie ist beweglich und weist eine homogene Dicke auf.

Als nachfolgende thermische Behandlung ist neben einem Sinterprozess insbesondere ein partieller Schmelzschritt (partial or incongruent melting) geeignet. Dabei wird das Formteil unter kontrollierter Atmosphäre kurzzeitig bis auf eine Temperatur im Bereich der Schmelztemperatur von 900°C erwärmt und wieder abgekühlt. Dadurch wird das keramische Formteil verdichtet und die Ausbildung der supraleitenden Phase unterstützt. Als thermische Nachbehandlung kann die Abkühlung schrittweise, d.h. über ein oder mehrere Langzeitglühen bei bestimmten Temperaturen, erfolgen. Die resultierenden Eigenschaften des Materials, insbesondere die kritische Stromdichte j_{c}, hängen in nichttrivialer Weise vom Precursormaterial und den thermischen Behandlungen ab.

Das keramische, pulverförmige Precursormaterial zur Herstellung von hochtemperatursupraleitenden Bauteilen oder Leitern sollte eine kleine Teilchengrösse und eine hohe Reinheit, insbesondere einen geringen Kohlenstoffgehalt aufweisen. Zur Herabsetzung des Kohlenstoffgehalts werden Ausgangsmischungen bei einer bestimmten Temperatur mehrfach während einiger Stunden thermisch behandelt und dazwischen gemahlen und gesiebt. Je nach Temperatur und Dauer dieses Prozesses beginnt sich dabei die supraleitende Bi2212 Phase auszubilden und findet ein unerwünschtes partielles Sintern statt.

In der EP-A 630 874 wird ein Verfahren zur Herstellung rohrförmiger Bauteile aus Hoch-T_{c} Material offenbart, welches die Vorteile des Foliengiessens ausnutzt. Das bevorzugt verwendete Precursormaterial wird dabei nasschemisch hergestellt, beispielsweise mittels einer Copräzipitation als Oxalatfällung gewonnen. Zur Vorpräparierung wird das Precursormaterial anschliessend thermisch behandelt und bei Temperaturen unterhalb 800°C in einer sauerstoffhaltigen Atmosphäre vorkalziniert oder vorzersetzt. Oxalatcopräzipitate weisen eine hohe chemische Reaktivität auf, so dass eine Kalziniertemperatur im Bereich von 750°C während weniger als einer Stunde oder alternativ eine Temperatur von 450°C während 10 Stunden ausreichend sind zur Reduzierung des Kohlenstoffgehalts. Die thermische Behandlung und die vorgängige Ausfällung des Oxalats jedoch sind zusätzliche Arbeitsschritte, welche sich in höheren Herstellungskosten niederschlagen.

### DARSTELLUNG DER ERFINDUNG

Aufgabe der vorliegenden Erfindung ist es, ein Verfahren zur Herstellung von Formteilen aus Hochtemperatursupraleitermaterial anzugeben, welches einfach und kostengünstig ist und in dicken Schichten zu hohen kritischen Stromdichten j_{c} führt. Diese Aufgabe wird durch ein Verfahren zur Herstellung hochtemperatursupraleitender Formteile mit den Merkmalen des Patentanspruchs 1 gelöst.

Kern der Erfindung ist es, die Elemente des Supraleitermaterials im annähernd korrekten stöchiometrischen Verhältnis trocken zu mischen und dieses Gemisch unmittelbar oder über einen partiellen Kalzinierprozess als unvollständig reagiertes Precursormaterial einzusetzen. Es findet also kein nasschemischer Zwischenschritt oder Copräzipitation statt, was die Präparation des Precursormaterials vereinfacht. Der Erfindung liegt weiter die Erkenntnis zugrunde, dass es für die Erzielung einer guten kritischen Stromdichte j_{c} im resultierenden Formteil vorteilhaft ist, das Gemisch gar nicht oder nur unvollständig zu kalzinieren, d.h. dass das dementsprechend nur unvollständig reagierte Precursorpulver selbst nicht phasenrein supraleitend zu sein braucht.

In einer ersten Ausführungsform des erfindungsgemässen Verfahrens wird insbesondere eine Cu₂O enthaltende Verbindung als Ausgangsprodukt verwendet.

Gemäss einer zweiten bevorzugten Ausführungsform erfolgt der partielle Kalzinierschritt in zwei Stufen. Zuerst werden die Elemente Sr, Ca und Cu, d.h. unter Ausschluss des Bi, zusammengebracht und bei einer ersten Kalziniertemperatur vorkalziniert. Erst anschliessend wird eine Bi-haltige Verbindung zugegeben und bei einer zweiten Kalziniertemperatur zwischen 700°C und 830°C kalziniert.

Gemäss einer weiteren bevorzugten Ausführungsform ist zwischen dem Formteil und seiner Unterlage eine die Relativbewegung von Formteil und Unterlage erleichternde Pufferschicht, beispielsweise aus MgO vorgesehen. Dies deshalb, weil das unvollständig reagierte Precursormaterial nicht formbeständig ist und die Tendenz hat, sich vor dem nachfolgenden partiellen Schmelzschritt irreversibel auszudehnen.

Zur Formgebung ist insbesondere ein Foliengiessprozess geeignet. Die dergestalt erhaltenen untexturierten supraleitenden Schichten weisen eine durchgehend hohe kritische Stromdichte sowie eine Schichtdicke von bis zu einigen mm auf, so dass dank der resultierenden kritischen Stromstärke die Formteile für Anwendungen in der Energieübertragung geeignet sind.

Weitere vorteilhafte Ausführungsformen gehen aus den abhängigen Patentansprüchen hervor.

### WEGE ZUR AUSFÜHRUNG DER ERFINDUNG

Der erfindungsgemässe Prozess zur Herstellung des Bi2212 Precursormaterials und der daraus gebildeten Formteile umfasst im Detail die nachfolgend aufgeführten Schritte. Die resultierende stöchiometrische Zusammensetzung des supraleitenden Formteils kann im bekannten Rahmen von der nominellen 2212 Zusammensetzung abweichen, ebenso ist der teilweise Ersatz von Bi durch Pb weiterhin möglich. Das Verfahren lässt sich sinngemäss auch auf andere hochtemperatursupraleitende Verbindungen übertragen.

Ausgangsmaterial bilden Pulver mit über 99% Reinheit von die Kationen des Supraleitermaterials enthaltenden Verbindungen, also beispielsweise Oxide, Carbonate, Nitrate oder Sulfate wie Bi₂O₃, SrCO₃, Sr(NO₃)₂, CaO, CaCO₃, CuO, Cu₂O oder metallischem Cu. Insbesondere der Einsatz von Cu₂O hat sich dabei als vorteilhaft erwiesen und zu bei ansonsten identischen Prozessbedingungen bis zu 20% höheren kritischen Stromdichten geführt.

Die genannten Pulver werden trocken im richtigen Mengenverhältnis gemischt und eventuell nochmals gemahlen. Dieses Gemisch kann nun unmittelbar direkt als unkalziniertes Precursorpulver dem Formgebungsprozess zugeführt werden oder über einen bevorzugt zweistufigen partiellen Kalzinierprozess in ein teilweise reagiertes Precursorpulver überführt werden.

In einem ersten Schritt werden dabei die Elemente Sr, Ca und Cu beziehungsweise die sie enthaltenden Verbindungen trocken gemischt und dann bei einer ersten Kalziniertemperatur T_{K1} von ungefähr 900°C vorkalziniert. Da bei diesem ersten Kalzinierschritt kein Bi zugegen ist, liegt die Temperatur T_{K1} noch deutlich unterhalb des Schmelzpunktes des Bi-freien ersten Gemisches, und der Kohlenstoffgehalt wird durch Freisetzung von Carbonaten reduziert. Die resultierende lockere, ungesinterte Schüttung kann gegebenenfalls problemlos weiter gemahlen werden.

Daraufhin wird eine Bi-haltige Verbindung zugegeben und das erhaltene zweite Gemisch bei einer zweiten, unterhalb 830°C liegenden Kalziniertemperatur T_{K2} während bis zu 24 Stunden unter 02 kalziniert. Aus den weiter unten aufgeführten Gründen liegt diese zweite Temperatur T_{K2} vorzugsweise bei etwa 700°C. Da für eine vollständige Reaktion des zweiten Gemisches mit einer durchgehenden Ausbildung der supraleitenden Phase eine Temperatur von zumindest 840°C vonnöten ist, wird das erfindungsgemäss präparierte Pulver als unvollständig reagiert bezeichnet (partially reacted precursor).

Es folgt ein erneutes Mahlen (ball milling), wodurch die Teilchengrösse auf unter 50 µm, und vorzugsweise auf unter 20 µm gesenkt wird. Das dergestalt erhaltene Precursorpulver wird mit einem Binder, welcher vorzugsweise nicht-wässrig ist und Polyvinilbutyral, Polyethylenglykol und Phtalsäureester umfasst, sowie Dispergier- und Lösungsmitteln gemischt. Diese Giessmasse oder Schlicker (slurry) kann in einem versiegelten Gefäss nochmals gemahlen werden.

Der nun folgende Foliengiessprozess führt zu einer Grünfolie (green tape) bestimmter Dicke, welche anschliessend bei Raumtemperatur oder leicht darüber getrocknet wird, wodurch sich das Lösungsmittel verflüchtigt. Die Folie ist in diesem Zustand dank dem Polymer-Netzwerk des Binders immer noch flexibel und kann geformt werden. Bei einer erhöhten Temperatur von gegen 500°C wird der Binder ausgeheizt. Darauf folgt ein partieller Schmelzschritt bei rund 880-900°C und eine thermische Nachbehandlung zur Einstellung des Sauerstoffgehalts, wobei sich die supraleitende Phase ausbildet und gleichzeitig die Dicke der Grünfolie um etwa 50% reduziert.

Die sich an das partielle Schmelzen anschliessenden thermischen Nachbehandlungen (post annealing) des Formteils finden bei bestimmten Temperaturen und unter kontrollierter Atmosphäre statt. Ein zweistufiger Prozess umfasst beispielsweise eine erste Nachbehandlung bei 850°C in einer oder nacheinanderfolgend mehrerer der folgenden Atmosphären: Sauerstoff, Luft, Stickstoff/Sauerstoff Gemisch mit einem Sauerstoffpartialdruck pO₂ von weniger als 0.21 und bevorzugt weniger als 0.1, gefolgt von einer zweiten Nachbehandlung von bis zu 100 Stunden Dauer bei 820°C in Luft.

Es hat sich gezeigt, dass die kritische Stromdichte j_{c} entscheidend von der zweiten Kalziniertemperatur T_{K2} beeinflusst wird. Insbesondere wurde festgestellt, dass bei T_{K2} oberhalb 700°C die kritische Stromdichte j_{c} des resultierenden Formteils mit zunehmender Kalziniertemperatur wieder abnimmt. Es ist also nachteilig, das Precursormaterial vollständig zu reagieren, erfindungsgemäss wird es deshalb unvollständig, d.h. gar nicht oder bei tieferen Kalziniertemperaturen nur teilweise, reagiert. Andererseits ist das unvollständig reagierte Precursorpulver nicht formbeständig und expandiert bei der folgenden Erwärmung bei Temperaturen oberhalb 700°C (de-sintering), ohne beim partiellen Schmelzen wieder zu schrumpfen.

Diese Tatsache ist insbesondere für die durch die Foliengiessprozesse erhaltenen grossflächigen zweidimensionalen Formteile relevant. Die erwähnte Formunbeständigkeit bedingt nämlich, dass die Grünschicht nicht auf ihrer Unterlage kleben bleibt, sondern sich bei den thermischen Behandlungen frei bewegen kann. Ansonsten ist mit spannungsinduzierten Deformationen der supraleitenden Schicht zu rechnen. Zu diesem Zweck wird eine geeignete, gegenüber dem Supraleiter chemisch inerte Zwischenschicht, beispielsweise aus MgO, SrZrO₃, ZrO₂, SrSO₄, Ce₂O₃, Y₂O₃, oder Bi2212 zwischen der Unterlage und dem Supraleiter vorgesehen. Vorzugsweise besteht die genannte Unterlage, auf welche entweder die Foliengiessmasse direkt gegossen oder der getrocknete Grünkörper gelegt wird, aus Silber oder einem anderen Metall, welches nach dem partiellen Schmelzen als elektrischer Bypass am Supraleiter verbleibt. In diesem Fall soll die Zwischenschicht den Supraleiter nicht vom Bypass elektrisch isolieren. Dies wird erreicht durch eine minimale Dimensionierung Letzterer mit einer Dicke von weniger als 50 µm, welche sich nach erfolgter Ausdehnung der Grünfolie beim partiellen Schmelzen im Supraleiter auflöst.

In einem konkreten Beispiel wurde auf diese Art eine 300 µm dicke supraleitende Schicht mit einer kritischen Stromdichte bei 77 K von über 5000 A/cm² erhalten. Aus dieser Schicht wurden anschliessend Bahnen von 2-3 cm Breite geschnitten und somit Nennstromstärken von einigen hundert Ampere erreicht.

Zu Vergleichszwecken wurden Proben gefertigt aus teilweise sowie vollständig reagiertem Precursormaterial, und während 5 Stunden in Sauerstoff und anschliessend während 15 Stunden in Luft bei 850°C nachbehandelt. Die gemessenen j_{c} Werte betrugen 5500 A/cm² für die Probe aus teilweise reagiertem Precursormaterial und 3500 A/cm² für die Vergleichsprobe.

## Patentansprüche

1. Verfahren zur Herstellung hochtemperatursupraleitender Formteile, wobei ein pulverförmiges Precursormaterial der nominellen Zusammensetzung Bi₂Sr₂CaCu₂O_{8+δ} mittels eines Formgebungsprozesses in eine bestimmte Form gebracht wird und anschliessend durch einen partiellen Schmelzschritt zum supraleitenden Formteil umgesetzt wird,
**dadurch gekennzeichnet, dass**
die Elemente Bi, Sr, Ca, Cu und O in einem zumindest annähernd stöchiometrischen Verhältnis trocken gemischt werden und ein dergestalt erhaltenes Gemisch unmittelbar oder über einen partiellen Kalzinierungsprozess als unvollständig reagiertes, pulverförmiges Precursormaterial eingesetzt wird.

2. Verfahren nach Anspruch 1, **dadurch gekennzeichnet, dass** Cu in Form von Cu₂O und die restlichen Elemente in Form von Oxid-, Carbonat-, Sulfat- oder Nitratverbindungen gemischt werden.

3. Verfahren nach Anspruch 1, **dadurch gekennzeichnet, dass** ein erstes Gemisch unter Ausschluss von Bi bei einer ersten Kalziniertemperatur T_{K1} von 800-1000°C vorkalziniert wird.

4. Verfahren nach Anspruch 3, **dadurch gekennzeichnet, dass** dem vorkalzinierten ersten Gemisch eine Bi-haltige Verbindung zugemischt wird und das dergestalt erhaltene zweite Gemisch bei einer zweiten Kalziniertemperatur T_{K2} von 700-830°C kalziniert wird.

5. Verfahren nach Anspruch 1, **dadurch gekennzeichnet, dass** während dem partiellen Schmelzen das Formteil gegenüber einer Unterlage beweglich ist.

6. Verfahren nach Anspruch 5, **dadurch gekennzeichnet, dass** während dem partiellen Schmelzen zwischen dem Formteil und der Unterlage eine Pufferschicht aus MgO liegt.

7. Verfahren nach Anspruch 1, **dadurch gekennzeichnet, dass** der Formgebungsprozesses ein Foliengiessverfahren ist und das Formteil eine untexturierte dicke Schicht ist.

8. Verfahren nach Anspruch 1, **dadurch gekennzeichnet, dass** anschliessend an das partielle Schmelzen eine erste thermische Nachbehandlung bei ungefähr 850°C unter einer Stickstoff/Sauerstoff Atmosphäre mit einem Sauerstoffpartialdruck pO₂ von weniger als 0.1 erfolgt.

9. Verfahren zur Herstellung eines pulverförmigen Precursormaterials der nominellen Zusammensetzung Bi₂Sr₂CaCu₂O_{8+δ},
**dadurch gekennzeichnet, dass**
die Elemente Bi, Sr, Ca, Cu und O in einem zumindest annähernd stöchiometrischen Verhältnis trocken gemischt werden und ein dergestalt erhaltenes Gemisch über einen partiellen Kalzinierungsprozess unvollständig reagiert wird.
